Europäisches Patentamt

European Patent Office

Office européen des brevets

(19)

(11) Numéro de publication: **0 276 607 B1**

(12) **FASCICULE DE BREVET EUROPEEN**

(45) Date de publication de fascicule du brevet:
21.11.91

(51) Int. Cl.⁵: **H05K 7/20**

(21) Numéro de dépôt: 87402948.1

(22) Date de dépôt: **22.12.87**

(54) **Dispositif de ventilation de composants disposés en rangées sur une plaque.**

(30) Priorité: 30.12.86 FR 8618322

(43) Date de publication de la demande:
03.08.88 Bulletin 88/31

(45) Mention de la délivrance du brevet:
21.11.91 Bulletin 91/47

(84) Etats contractants désignés:
DE FR GB IT NL SE

(56) Documents cités:
EP-A- 0 019 780
EP-A- 0 217 676
FR-A- 2 157 094
FR-A- 2 570 920
US-A- 4 449 164

(73) Titulaire: **BULL S.A.**
**121, Avenue de Malakoff**
**F-75116 Paris(FR)**

(72) Inventeur: **Bonnefoy, Jean**
**7, rue de la Sansonnerie**
**F-78121 Crespières(FR)**

(74) Mandataire: **Denis, Hervé et al**
**BULL S.A. Industrial Property Department**
**P.C.: HQ 8M006 P.B. 193.16 121 avenue de**
**Malakoff**
**F-75764 Paris Cédex 16(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

Rank Xerox (UK) Business Services

## Description

L'invention se rapporte à un dispositif de ventilation de composants disposés en rangées sur une plaque. Elle s'applique notamment au refroidissement par ventilation de composants semiconducteurs tels que des boîtiers de circuits intégrés de haute densité, disposés en rangées sur une plaque de circuits imprimés, comme connu par exemple du document EP-A-0019 780.

Les circuits intégrés de haute densité, encore appelés chips VLSI (Very Large Scale Integration) dissipent actuellement de fortes puissances thermiques à travers une faible surface. Par exemple, les circuits intégrés du type N-MOS peuvent dissiper actuellement de l'ordre de 5 Watts à travers une surface d'un cm² environ. Un circuit intégré N-MOS est une pastille semiconductrice dont les composants actifs sont des transistors à effet de champ du type MOS (Métal Oxyde Semiconducteur) à canal N. Chaque circuit intégré est monté dans un boîtier pourvu d'un échangeur de chaleur pour l'évacuation des calories. L'invention concerne des échangeurs de chaleur incluant une interface métal-air et couramment appelés radiateurs. A l'heure actuelle, un radiateur pour boîtier VLSI se présente ordinairement sous la forme d'une colonne massive en matériau bon conducteur thermique, pourvue d'ailettes sous forme de couronnes concentriques régulièrement espacées suivant la longueur de la colonne. Dans les machines électroniques complexes, telles que les machines de traitement de l'information, les boîtiers sont reliés électriquement en les disposant sur une ou plusieurs plaques de circuits imprimés. Compte tenu du faible encombrement recherché pour chaque boîtier VLSI, une plaque pourra très prochainement comporter un nombre relativement élevé de boîtiers. Le problème se posera alors d'évacuer, par ventilation des radiateurs, une très forte quantité de chaleur concentrée sur une plaque de faible surface.

Dans la technique antérieure, le refroidissement de composants moins dissipatifs disposés en rangées sur une plaque se faisait par une ventilation en série des composants de chaque rangée. Le dispositif de refroidissement est simple, mais il présente l'inconvénient de ventiler les derniers composants de la rangée par de l'air qui s'est réchauffé au contact des composants précédents. Divers perfectionnements ont été apportés, notamment celui consistant à accélérer le flux d'air de refroidissement au fur et à mesure qu'il se réchauffe, en faisant passer l'air dans une canalisation de section de plus en plus petite. Cependant, avec des composants très dissipatifs, le flux d'air se réchauffe très vite au contact des premiers composants en ne peut plus convenablement refroidir les composants suivants. Il faudrait alors augmenter considérablement le débit d'air et sa vitesse au moyen de ventilateur très puissants et très bruyants. Mais il est évident que le bruit doit être le plus bas possible, surtout pour les machines informatiques de bureau notamment.

Une solution pour le refroidissement de composants à forte dissipation calorifique est exposée dans le brevet français n° 2 157 094. Le principe de cette solution est de ventiler séparément chaque composant avec le même air frais d'entrée. Selon un mode de réalisation, le conduit d'entrée d'air frais enveloppe la face de la plaque qui porte les composants, et le conduit de sortie d'air chaud recouvre l'autre face. L'air frais d'entrée est ainsi mis directement au contact de tous les composants et sort par des trous ménagés dans la plaque pour être évacué dans le conduit de sortie.

Ce mode de réalisation présente deux inconvénients majeurs. D'une part, l'assemblage de deux conduits sur les deux faces respectives, d'une plaque de circuits imprimés est compliqué. L'ensemble est encombrant en épaisseur, et son montage dans une machine est rendu difficile. D'autre part, il est clair que l'évacuation de fortes puissances calorifiques exige une ventilation à grand débit. Les trous ménagés dans le plaque pour le passage de l'air chaud dans le conduit de sortie doivent donc avoir une grande section. La présence d'aussi grands trous se fait au détriment de la concentration des circuits imprimés dans la plaque et fait perdre l'avantage de pouvoir utiliser des plaques de faible surface. Il est possible de réduire la section des trous, mais des trous plus petits accroissent la résistance au flux d'air. Cette résistance doit être compensée par une surpuissance de la source de ventilation, qui devient alors plus bruyante. Par contre, ce mode de réalisation est indépendant de la disposition des composants entre eux et n'exige pas une disposition des composants en rangées.

Le but de l'invention est de refroidir des composants très dissipatifs disposés en rangées sur une plaque, au moyen d'une source de ventilation peu bruyante et d'un dispositif de ventilation des composants qui soit très simple, peu encombrant et qui procure un refroidissement efficace des composants grâce à un fort débit d'air admissible.

Selon l'invention, un dispositif de ventilation de composants disposés en rangées sur une plaque, comprenant un conduit d'entrée d'air frais et un conduit de sortie, est caractérisé par les caractéristiques de la revendication 1.

Les caractéristiques et avantages de l'invention ressortiront de la description qui suit, donnée à titre d'exemple et faite en référence aux dessins annexés.

Dans les dessins :

- la figure 1 illustre, par une vue en coupe suivant la ligne I-I indiquée à la figure 2 et par des arrachements partiels, un dispositif de ventilation conforme à l'invention pour le refroidissement des composants disposés en rangées sur une plaque de circuits imprimés;
- la figure 2 est une vue de dessus du dispositif de ventilation représenté sur la figure 1 suivant la coupe II-II;
- la figure 3 illustre le dispositif de ventilation vu suivant la coupe II-II indiquée à la figure 2 et sous des arrachements partiels; et
- la figure 4 est une vue similaire à celle de la figure 2, illustrant une variante de réalisation d'un dispositif de ventilation conforme à l'invention.

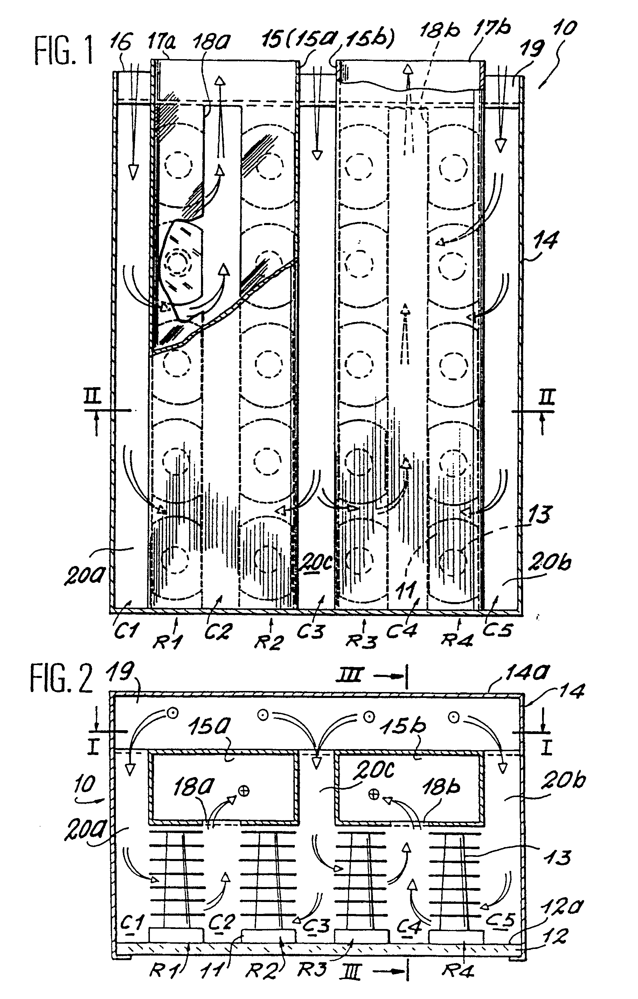

Les figures 1, 2 et 3 illustrent le mode de réalisation préféré d'un dispositif de ventilation 10 conforme à l'invention des composants 11 disposés en rangées sur une même face 12a d'une plaque de circuits imprimés 12. Quatre rangées R1-R4 de composants 11 sont représentées, qui délimitent entre elles et avec les bords de la plaque cinq couloirs C1-C5. Chaque composant 11 est un boîtier VLSI pourvu d'un radiateur 13. Chaque radiateur illustré se compose d'une colonne pourvue d'ailettes en forme d'anneaux concentriques régulièrement espacés. Le refroidissement des composants il se fait ainsi par ventilation de leurs radiateurs respectifs 13. De manière classique, le dispositif de ventilation 10 comprend un conduit 14 d'entrée d'air frais et un conduit 15 de sortie. Les deux conduits sont montés sur la même face 12a de la plaque 12.

Selon l'invention, les deux conduits 14, 15 débouchent respectivement sur les deux côtés latéraux d'au moins une rangée de composants. Dans l'exemple illustré, les deux conduits 14, 15 débouchent alternativement sur les cinq couloirs C1-C5 qui constituent respectivement les côtés latéraux de chaque rangée R1-R4.

Le conduit d'entrée 14 enveloppe tous les composants 11 et forme avec la plaque 12 une gaine parallélépipédique rectangle. Le conduit d'entrée 14 illustré présente une entrée d'air frais 16 rectangulaire ménagée le long d'un côté de la plaque 12 et adjacente au plafond 14a du conduit 14. Le conduit 15 est contenu dans le conduit 14 et se compose de deux compartiments 15a, 15b en forme de parallélipipèdes rectangles qui s'étendent dans les sens des rangées R1-R4 au-dessus des radiateurs 13 des composants 11. Ils traversent le conduit d'entrée 14 sous l'entrée 16 et présentent de ce côté des ouvertures respectives 17a, 17b pour la sortie de l'air du dispositif de ventilation 10. Ils sont fermés sur le côté opposé par la paroi du conduit d'entrée 14. La face inférieure de chaque compartiment recouvre uniformément les radiateurs 13 de deux rangées adjacentes de composants 11 et présente une ouverture longitudinale le long du couloir central qui sépare les deux rangées. Ainsi, le compartiment 15a recouvre les rangées R1 et R2 des radiateurs 13 et son ouverture 18a débouche sur le couloir C2. Le compartiment 15b recouvre les rangées R3 et R4 et son ouverture 18b débouche sur le couloir C4. Les compartiments 15a et 15b du conduit 15 laissent sous la face supérieure 14a du conduit 14 l'espace d'une chambre 19, tandis qu'ils forment entre eux, ainsi qu'avec les faces latérales du conduit 14, trois canaux 20a, 20b, 20c débouchant respectivement sur les couloirs C1, C5 et C3. Les canaux latéraux 20a et 20b sont formés dans le conduit 14 par le conduit 15 composé de tous ses compartiments 15a, 15b.

Les flèches représentées sur les figures 1 à 3 illustrent bien le chemin suivi par l'air de refroidissement véhiculé dans le dispositif 10 conforme à l'invention. L'air frais entrant par l'ouverture 16 du conduit 14 se répand dans la chambre 19 et se répartit entre les canaux 20a-20c.

L'air frais issu du canal 20a s'écoule dans le couloir C1 et refroidit chaque radiateur 13 de la rangée R1 de composants 11. L'air chaud arrive ainsi dans le couloir C2 et passe par l'ouverture 18a dans le compartiment 15a pour être évacué à la sortie 17a. Par symétrie, l'air frais issu du canal 20b s'écoule dans le couloir C5, se réchauffe au contact des radiateurs de la rangée R4, arrive dans le couloir C4, et passe par l'ouverture 18b dans le compartiment 15b du conduit 15 jusqu'à la sortie 17b. Enfin, l'air frais issu du canal 20c d'écoule dans le couloir C3 et se partage pour ventiler les radiateurs des rangées R2 et R3. L'air chaud est respectivement récupéré dans les couloirs C2 et C4, puis évacué par les compartiments 15a et 15b du conduit de sortie 15. Avantageusement, on adaptera les sections des canaux 20a, 20b et 20c de façon à équilibrer les débits d'air respectifs.

Les avantages du dispositif de ventilation 10 conforme à l'invention apparaissent maintenant clairement. Chaque composant 11 de la plaque 12 reçoit l'air frais d'entrée.

De plus, les radiateurs 13 sont ventilés dans le sens des ailettes, parallèlement au plan de la plaque 12. Ils peuvent donc admettre un grand débit d'air avec une résistance à l'air minimale. En conclusion, le dispositif de ventilation 10 conforme à l'invention a l'avantage d'avoir une structure simple et compacte et de refroidir les composants de façon optimale et égale. Cet avantage est dû à la ventilation d'une rangée de composants 11, faite perpendiculairement à la rangée et parallèlement au plan de la plaque 12.

On comprend alors que le dispositif de ventilation 10 qui vient d'être décrit peut recevoir de nombreuses variantes. Par exemple, les radiateurs 13 peuvent aussi être d'un autre type classique, formé d'un support plan horizontal pourvu d'ailettes planes parallèles et verticales. Dans ce cas, les ailettes seront dirigées perpendiculairement à la rangée pour que l'air passe aisément d'un couloir à un autre conformément aux principes de l'invention. Il est clair aussi que les rangées de composants, ordinairement des lignes droites comme celles illustrées, peuvent être généralement des lignes courbes ou brisées . De même, toute autre configuration pour l'entrée 16 et les sorties 17a et 17b peut être adoptée. Notamment, les sorties 17a et 17b pourraient être ménagées sur le côté opposé à celui ayant l'entrée 16, ou l'entrée 16 pourrait être faite dans la face supérieure 14a du conduit 14 selon une ou plusieurs ouvertures. De plus, il est évident qui le flux d'air peut être inversé, de sorte que les compartiments 15a et 15b amènent l'air frais et le conduit 14 récupère l'air chaud. Par ailleurs, le trajet entre un canal d'amenée d'air frais et l'ouverture voisine 18 du conduit de sortie 15 peut inclure plus d'une rangée de radiateurs, et l'un des conduits 14 et 15 peut ne pas être inclu dans l'autre, comme cela est illustré dans la figure 4.

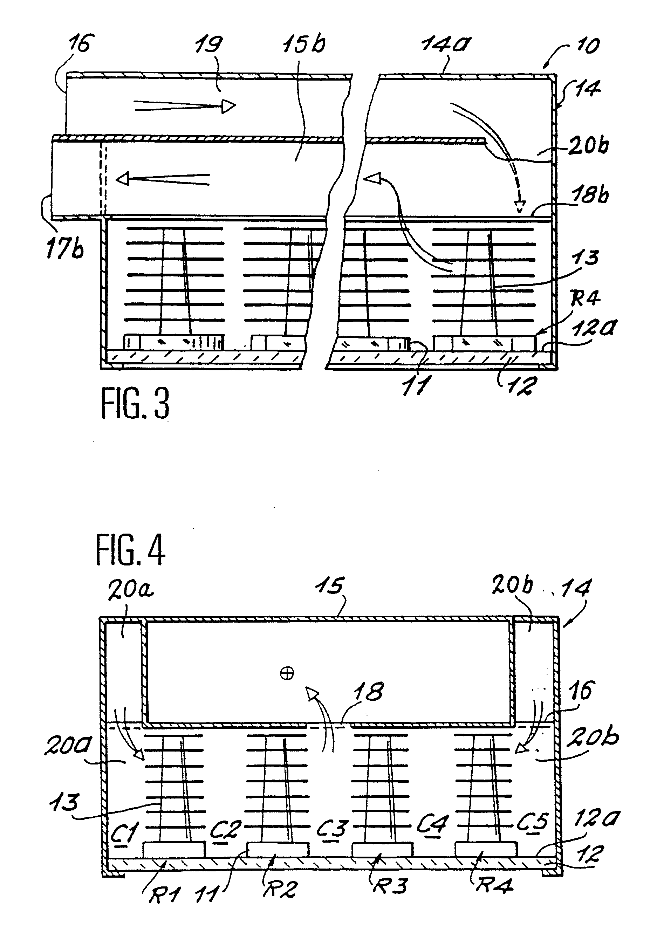

La figure 4 est une vue similaire à celle de la figure 2, illustrant une variante de réalisation d'un dispositif de ventilation 10 conforme à l'invention. Les éléments analogues entre les deux figures portent les mêmes chiffres de référence. Dans le dispositif de ventilation 10 représenté sur la figure 3, le conduit de sortie 15 est porté par le conduit d'entrée 14 et forme dans ce conduit deux canaux 20a, 20b. Le conduit 14 a une entrée 16 d'air frais, conduisant directement aux deux canaux 20a, 20b parallèles aux quatre rangées R1-R4 de composants 11 et débouchant sur les deux couloirs extrêmes C1 et C5. Le conduit 15 est placé entre les deux canaux 20a, 20b. Il recouvre les quatre rangées R1-R4 et débouche en 18 le long du couloir central C3. Ainsi, les deux conduits 14 et 15 débouchent respectivement sur les deux côtés latéraux (C1,C3; C5,C3) de deux rangées (R1,R2;R3,R4) de composants 11. L'air frais issu du canal 20a traverse les deux rangées R1, R2 de composants 11 avant d'entrer dans le conduit 15. De même, l'air frais issu du canal 20b refroidit les rangées R3, R4 des composants 11. Dans cette variante du dispositif de ventilation 10 conforme à l'invention, on voit que les canaux 20a et 20b pourraient être supprimés ou déplacés de manière que l'entrée 16 soit placée le long des parois latérales du conduit 14, au niveau des radiateurs 13 et selon la même hauteur environ.

**Revendications**

1. Dispositif de ventilation (10) pour le refroidissement de composants (11) pourvus de radiateurs (13) et montés sur une face (12a) d'une plaque (12), comprenant un premier conduit (14) enveloppant tous les composants et leurs radiateurs et communiquant avec un second conduit (15) contenu dans le premier conduit et disposé au-dessus des radiateurs des composants, dans le premier conduit les composants étant disposés dans le premier conduit en rangées (R1-R4) séparées par des couloirs (C1-C5), caractérisé en ce que les deux conduits communiquent entre eux par des ouvertures intérieures (20a ; 18a) débouchant respectivement sur des couloirs différents (C1, C2), les radieteurs permettant le passage de l'air entre ces overtures intérieurs.

2. Dispositif selon la revendication 1, caractérisé en ce que les parois supérieures (14a, 15a) des deux conduits constituent une chambre (19).

3. Dispositif selon la revendication 1, caractérisé en ce que les parois supérieures des deux conduits sont communes (fig 4).

4. Dispositif selon l'une des revendications 1 à 3, caractérisé en ce que les premier et second conduits ont des parois latérales respectives formant au moins une ouverture intérieure (20a) du premier conduit.

5. Dispositif selon l'une des revendications 1 à 4, caractérisé en ce que le second conduit se compose d'au moins deux compartiments (15a, 15b) présentant chacun une ouverture intérieure (18a, 18b) débouchant sur un couloir respectif (C2, C4), deux compartiments voisins étant séparés l'un de l'autre par un canal (20c) constituant une ouverture intérieure pour le premier conduit et débouchent sur un autre couloir (C3).

6. Dispositif selon l'une des revendications 1 à 5, caractérisé en ce que les radiateurs ont des ailettes sensiblement parallèles à la plaque.

7. Dispositif selon l'une des revendications 1 à 5, caractérisé en ce que les radiateurs ont des ailettes sensiblement perpendiculaires à la plaque.

**Claims**

1. A ventilation device (10) for cooling components (11) provided with heat sinks (13) and mounted on one face (12a) of a substrate (12), comprising a first conduit (14) enveloping all the components and their heat sinks and communicating with a second conduit (15) contained within the first conduit and arranged above the heat sinks of the components in the first conduit, the components being arranged in rows (R1-R4) separated by corridors (C1-C5), characterised in that the two conduits communicate between themselves by internal openings (20a; 18a) discharging respectively into different corridors (C1, C2), the heat sinks allowing the passage of air between these internal openings.

2. A device according to Claim 1, characterised in that the upper walls (14a, 15a) of the two conduits constitute a chamber (19).

3. A device according to Claim 1, characterised in that the upper walls of the two conduits are common (Fig. 4).

4. A device according to any of Claims 1 to 3, characterised in that the first and second conduits have respective lateral walls forming at least one internal opening (20a) in the first conduit.

5. A device according to any of Claims 1 to 4, characterised in that the second conduit consists of at least two compartments (15a, 15b) each having an internal opening (18a, 18b) discharging into a respective corridor (C2, C4), two adjacent compartments being separated from one another by a channel (20c) constituting an internal opening for the first conduit and discharging into another corridor (C3).

6. A device according to any of Claims 1 to 5, characterised in that the heat sinks have fins which are substantially parallel to the substrate.

7. A device according to any of Claims 1 to 5, characterised in that the heat sinks have fins which are substantially perpendicular to the substrate.

**Patentansprüche**

1. Belüftungsvorrichtung (10) für die Kühlung von Bauelementen (11), die mit Kühlkörpern (13) versehen sind und auf einer Seite (12a) einer Platte (12) angebracht sind, mit einem ersten, sämtliche Bauelemente und deren Kühlkörper umgebenden Kanal, der mit einem in dem ersten Kanal und oberhalb der Kühlkörper der Bauelemente angeordneten zweiten Kanal (15) in Verbindung steht, wobei die Bauelemente im ersten Kanal in Reihen (R1-R4), die durch längliche Zwischenräume (C1-C5) getrennt sind, angeordnet sind, dadurch gekennzeichnet, daß die zwei Kanäle miteinander über innere Öffnungen (20a; 18a), die jeweils in verschiedene längliche Zwischenräume (C1, C2) münden, verbunden sind, wobei die Kühlkörper den Durchgang der Luft zwischen diesen inneren Öffnungen ermöglichen.

2. Vorrichtung gemäß Anspruch 1, dadurch gekennzeichnet, daß die oberen Wände (14a, 15a) der zwei Kanäle eine Kammer (19) bilden.

3. Vorrichtung gemäß Anspruch 1, dadurch gekennzeichnet, daß die zwei Kanäle gemeinsame obere Wände besitzen (Fig. 4).

4. Vorrichtung gemäß einem der Ansprüche 1 bis 3, dadurch gekennzeichnet, daß der erste und der zweite Kanal jeweils Seitenwände besitzt, die wenigstens eine innere Öffnung (20a) des ersten Kanals bilden.

5. Vorrichtung gemäß einem der Ansprüche 1 bis 4, dadurch gekennzeichnet, daß der zweite Kanal aus wenigstens zwei Abteilungen (15a, 15b) zusammengesetzt ist, die jeweils eine innere Öffnung (18a, 18b), die in einen entsprechenden länglichen Zwischenraum (C2, C4) münden, aufweisen, wobei zwei benachbarte Abteilungen voneinander durch einen Kanal (20c), der für den ersten Kanal eine innere Öffnung darstellt und in einen anderen länglichen Zwischenraum (C3) mündet, getrennt sind.

6. Vorrichtung gemäß einem der Ansprüche 1 bis 5, dadurch gekennzeichnet, daß die Kühlkörper Flügel aufweisen, die zur Platte im wesentlichen parallel sind.

7. Vorrichtung gemäß einem der Ansprüche 1 bis 5, dadurch gekennzeichnet, daß die Kühlkörper Flügel aufweisen, die zur Platte im wesentlichen senkrecht sind.

FIG. 1

FIG. 2

FIG. 3

FIG. 4